(19) Europäisches Patentamt

European Patent Office

Office européen des brevets

(11) **EP 1 435 712 B1**

(12) **EUROPEAN PATENT SPECIFICATION**

(45) Date of publication and mention
of the grant of the patent:
**26.10.2005 Bulletin 2005/43**

(51) Int Cl.⁷: **H04L 25/02**, H03K 4/02

(21) Application number: **02293270.1**

(22) Date of filing: **31.12.2002**

(54) **Transmitter for transmitting a shape-controlled signal over a communication line**

Sender zum Übertragen eines Signals mit kontrollierter Signalform über eine Kommunikationsleitung

Emetteur pour transmettre un signal ayant une forme de signal contrôlée sur une ligne de communication

(84) Designated Contracting States:
**AT BE BG CH CY CZ DE DK EE ES FI FR GB GR
IE IT LI LU MC NL PT SE SI SK TR**

(43) Date of publication of application:
**07.07.2004 Bulletin 2004/28**

(73) Proprietor: **Freescale Semiconductor, Inc.
Austin, Texas 78735 (US)**

(72) Inventor: **Sicard, Thierry
31170 Tournefeuille (FR)**

(74) Representative: **Wharmby, Martin Angus
Freescale Semiconductor Inc.
c/o Impetus IP Limited
Grove House
Lutyens Close
Basingstoke, Hampshire RG24 8AG (GB)**

(56) References cited:
**EP-A- 1 143 617          US-A1- 2002 154 651
US-B1- 6 169 433**

# EP 1 435 712 B1

**Description**

<u>Field of the invention</u>

This invention relates to a transmitter for a controlled-shape switched signal on a communication line.

<u>Background of the invention</u>

Local networks often make use of a communication line, such as a communication bus, over which a set of nodes communicates. A driver module in a master node applies power to the line, the driver module being switched to produce step changes in the power in the line to transmit signals to receivers in remote slave nodes over the line. The switched power signal activates the multiplexed remote nodes connected to the line and the line, also selectively transmits signals from the remote nodes back to a central processing unit.

Such a bus is used in automotive vehicles, for example, the bus comprising either a single line or a twisted pair of conductors in which the current flows. An important performance feature of transmitter nodes is reduced electromagnetic susceptibility ('EMS'), the sensitivity to electromagnetic interference ('EMI'), that is to say reception of noise induced in the wire or wires of the bus, as well as the electromagnetic compatibility ('EMC'), that is to say low radiation of parasitic fields by the currents flowing in the wires of the bus; both are critical parameters, especially in automotive applications.

Historically, in automotive applications, functions such as door locks, seat positions, electric mirrors, and window operations have been controlled directly by electrical direct current delivered by wires and switches. Such functions may today be controlled by ECUs (Electronic Control Units) together with sensors and actuators in a multiplexed Controller Area Network (CAN). The Controller Area Network (CAN) standard (ISO 11898) allows data to be transmitted by switching a voltage, at a frequency of 250kbauds to 1Mbaud for example, to the multiplexed receiver modules over the twisted pair cable. The receiver modules may be actuators that perform a function, for example by generating mechanical power required, or sensors that respond to activation by making measurements and transmitting the results back to the ECU over the bus.

The CAN bus was designed to be used as a vehicle serial data bus, and satisfies the demands of real-time processing and reliable operation in a vehicle's EMI environment; it is cost-effective and provides a reasonable data bandwidth. However, connecting with the main body network directly via a CAN bus system can be expensive because of increased costs per node and because high overall network traffic can make management extremely difficult. To help reduce costs, the logical extension is to structure the network hierarchically.

A variant on the CAN standard is the LIN (Local Interconnect Network) sub-bus standard (see ISO 7498), which is an extension to the CAN bus, at lower speed and on a single wire bus, to provide connection to local network clusters. A LIN sub-bus system uses a single-wire implementation (enhanced ISO9141), which can significantly reduce manufacturing and component costs. Component costs are further reduced by self-synchronization, without crystal or ceramics resonator, in the slave node. The system is based on common Universal asynchronous receiver and transmitter serial communications interface (UART/SCI) hardware that is shared by most micro-controllers, for a more flexible, lower-cost silicon implementation.

It is often necessary to control accurately the shape of the leading and/or trailing edges of switched signals transmitted over the communication line. This is particularly the case where it is desired to minimise electromagnetic interference, by limiting the basic frequencies of electromagnetic emissions to certain acceptable frequency ranges and restricting the amplitudes of emissions of harmonics of the basic frequencies outside the acceptable range.

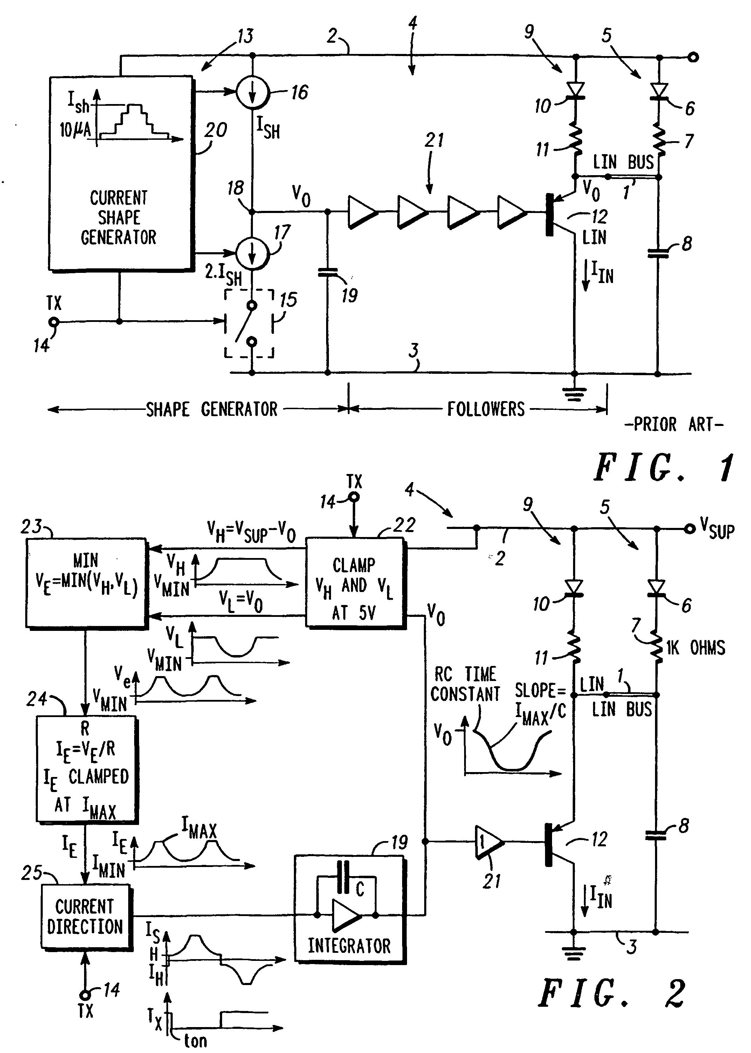

It is possible to generate signals to be transmitted with controlled shape by generating a current charging a capacitor to approximate the desired shape of the voltage signal, as shown in Figure 1. However, the capacitor stage has high impedance, with correspondingly low current (in some cases as low as 10μA) produced by this stage, so that several follower stages are needed and its components are subjected to the full voltage swings across the capacitor, so that they need to withstand such relatively high voltages.

Our co-pending European Patent Application EP02292729,7 filed 31st October 2002 and published 6th May 2004 (EP 1 416 632) describes transmitters of this kind that generate a carefully controlled shape for the transmitted signal edges, giving very good EMC. The present invention is applicable to the transmitters of our co-pending application and also to other transmitter designs, and provides an improvement in electromagnetic susceptibility.

European Patent Publication EP 1 143 617 discloses a circuit for producing a controlled shape signal comprising an integrator, a feedback loop and an amplifier stage.

<u>Summary of the invention</u>

The present invention provides a transmitter for a controlled-shape switched signal on a communication line as described in the accompanying claims.

Brief description of the drawings

Figure 1 is a block schematic diagram of a known signal generator in a transmitter for a communication bus line,

Figure 2 is a block schematic diagram of a signal generator in a transmitter for a communication bus line, in accordance with one embodiment of the present invention, given by way of example,

Figure 3 is a more detailed schematic diagram of a first part of the signal generator of Figure 2,

Figure 4 is a more detailed schematic diagram of a second part of the signal generator of Figure 2,

Figure 5 is a diagram illustrating the variation with time of an output voltage of the signal generator of Figures 2 3 and 4, and

Figure 6 is a more detailed schematic diagram of a follower stage in the signal generator of Figure 2

Detailed description of the preferred embodiments

Figure 1 shows a known communication system, comprising a LIN communication bus line 1, a power supply line 2, and a ground line 3 enabling communication between a transmitter node 4 and a receiver node 5. The receiver node 5 is shown schematically as comprising a diode 6 connected to the positive supply line 2, a resistor 7 connected in series with the negative pole of the diode 6, and a capacitor 8 connected between the other pole of the resistor 7 and the ground line 3, the LIN bus being a single conductor connected to the junction between the resistor 7 and the capacitor 8. It will be appreciated that the receiver node 5 is in practice associated with elements (not shown) such as signal processors and actuators for exploiting the received signals. The communication system comprising the lines 1, 2 and 3 and the transmitter node 4 and receiver node 5 may be installed in a vehicle or may be included in industrial applications, for example. It will also be appreciated that the system may be adapted to other communication standards, such as the CAN standard. According to the LIN standard, as shown, the physical LIN bus medium is a single wire connected via the termination resistor (pull-up) 7 to a positive voltage level, which, in automotive applications, will typically be the positive battery node. The idle state (communication pulse de-asserted) is high or recessive and the active state (communication pulse asserted) is low or dominant.

The transmitter node comprises an output stage 9 comprising a diode 10 whose positive pole is connected to the positive voltage supply line 2 and whose negative pole is connected to one terminal of a resistor 11, the emitter and collector terminals of a PNP transistor 12 being connected in series between the other terminal of the resistor 11 and the ground line 3.

The signal generator also comprises an input stage 13. A rectangular pulse data signal TX is applied to an input terminal 14, which is connected to control the opening and closing of a switch 15 connected to the ground line 3. A first current source 16 is connected in series with a second current source 17 through the switch 15 to ground. The connection 18 between the current sources 16 and 17 is connected to one pole of a capacitor 19 whose other pole is connected to the ground line 3. A current shape generator 20 receives a triggering input from the data signal input terminal 14, and controls the currents passed by the current sources 16 and 17, so that the currents change stepwise as indicated schematically. The current passed by the source 17 when the switch 15 is closed is $2.I_{SH}$, where $I_{SH}$ is the current passed by the current source 16.

In operation, the capacitor is charged to the voltage of the supply line 2 while the input signal at the terminal 14 is de-asserted. When the input signal *TX* at the terminal 14 is asserted, the switch 15 is closed and the net current $I_{SH}$ supplied by the current sources 16 and 17 increases step-wise to discharge the capacitor 19, the voltage across the capacitor 19 decreasing as a function of the integral of the current $I_{SH}$. At the falling edge of the input pulse, the switch 15 is opened, and the net current flowing to the capacitor 19, from the current source 16 alone, is inverted and increases step-wise until the capacitor is fully charged.

In practice, the order of magnitude of the current $I_{SH}$ is low, typically 10 micro amps maximum, for example, and due to this high impedance of the input stage, several follower stages 21 are required. The follower stages 21 apply a current proportional to the voltage across the capacitor 19 to the base of the transistor 12, so as to apply the output signal to the LIN bus 1.

The use of the digital current shape generator 20 enables different shapes of the rising and falling edges of the signal applied to the LIN bus 1 to be synthesised. The signal generator therefore enables the corners of the rectangular input pulse to be rounded. However, the step-wise nature of the charging current of the capacitor 19 introduces high rates of change of the charging current with time and introduces harmonics of the base frequency of the pulse edge on the LIN bus 1. Also, the current shape generator 20 is a relatively complex circuit, typically including several voltage comparators. Moreover, the current sources 16 and 17 are exposed to the full range of voltages across the capacitor 19, increasing the semiconductor area of the elements required to withstand the high voltages.

Figure 2 shows a signal generator in a transmitter in accordance with one embodiment of the present invention and which is derived from the signal generator described in our co-pending European Patent Application EP02292729,7. It will be appreciated the principles of the present invention are also applicable to other signal generators, however. The receiver node is again shown at 5 and the transmitter node at 4, with an output stage 9. A single follower stage 21 supplies the base of the transistor 12 of the output stage 9 with a current that is proportional to the voltage across the capacitor C of an integrator 19'.

The voltage across the integrator 19' is also supplied to a voltage generator 22 in a feedback loop. The voltage generator 22 produces a first voltage $V_L$ that is equal to the voltage $V_o$ across the integrator 19' up to a clamp value, of 5 volts in this example, and a second voltage $V_H$ that is equal to the supply voltage $V_{SUP}$ minus the voltage $V_o$ across the integrator 19', the voltage $V_H$ being also limited to the same clamp value. A selection circuit 23 produces a feedback voltage $V_E$ by selecting the lower of the two values $V_L$ or $V_H$. The feedback voltage $V_E$ is applied across a resistor R in a feedback current generator 24 so as to produce a feedback current $I_E$ which is equal to $V_E/R$, the feedback current $I_E$ being limited to a clamp value $I_{MAX}$. The feedback current $I_E$ is applied to a charging current generator 25 that selectively inverts the feedback current $I_E$ to produce a charging current $I_C$ that is applied to the integrator 19'. The input signal is applied to trigger the voltage generator 22 and pilot the charging current generator 25.

The voltage generator 22, selection circuit 23, feedback current generator 24 and inverter 25 constitute a feedback loop. In operation, at the rising edge of the rectangular data pulse applied to the input terminal 14, the voltage across the integrator 19', initially at the supply voltage $V_{SUP}$ is applied to the voltage generator 22. The voltage $V_H$ is initially smaller than the voltage $V_L$ and is selected by the selection circuit 23. The feedback voltage $V_E$ applied to the resistor R in the feedback current generator 24 produces a feedback current $I_E$ that is applied by the inverter 25 to the integrator 19' in a direction so as to reduce the charge of the capacitor C and hence the voltage $V_O$. Accordingly, the voltages $V_H$ and $V_E$ increase exponentially until the clamp voltage of the generator 22 is reached. The feedback voltage $V_E$ and the feedback current $I_E$ are then maintained at constant values, so that the voltage $V_O$ continues decreasing but linearly with time. When the voltage $V_L$ becomes smaller than the voltage $V_H$, the selection circuit 23 selects the voltage $V_L$. The voltage $V_E$ then decreases exponentially with time, so that the feedback current $I_E$ also decreases exponentially with time and the voltage $V_O$ across the integrator 19' changes progressively more and more slowly, until the feedback current $I_E$ reaches a minimum value $I_{MIN}$.

This half cycle is then repeated at the falling edge of the input pulse, with the charging current $I_C$ inverted by the inverter 25, so that the voltage $V_O$ across the integrator 19' progressively approaches the voltage $V_{SUP}$.

In this embodiment of the present invention, the voltages $V_H$ and $V_L$ are generated with an offset applied, so that their minimum value is equal to $V_{MIN}$ and never reduces to zero. The feedback current generator 24 generates the feedback current $I_E$ with a corresponding minimum value $I_{MIN}$. When the inverter 25 inverts the feedback current $I_E$ in response to an edge of the rectangular input signal TX, the shaped current $I_S$ applied the integrator 19' passes between the positive and negative values $\pm I_{MIN}$.

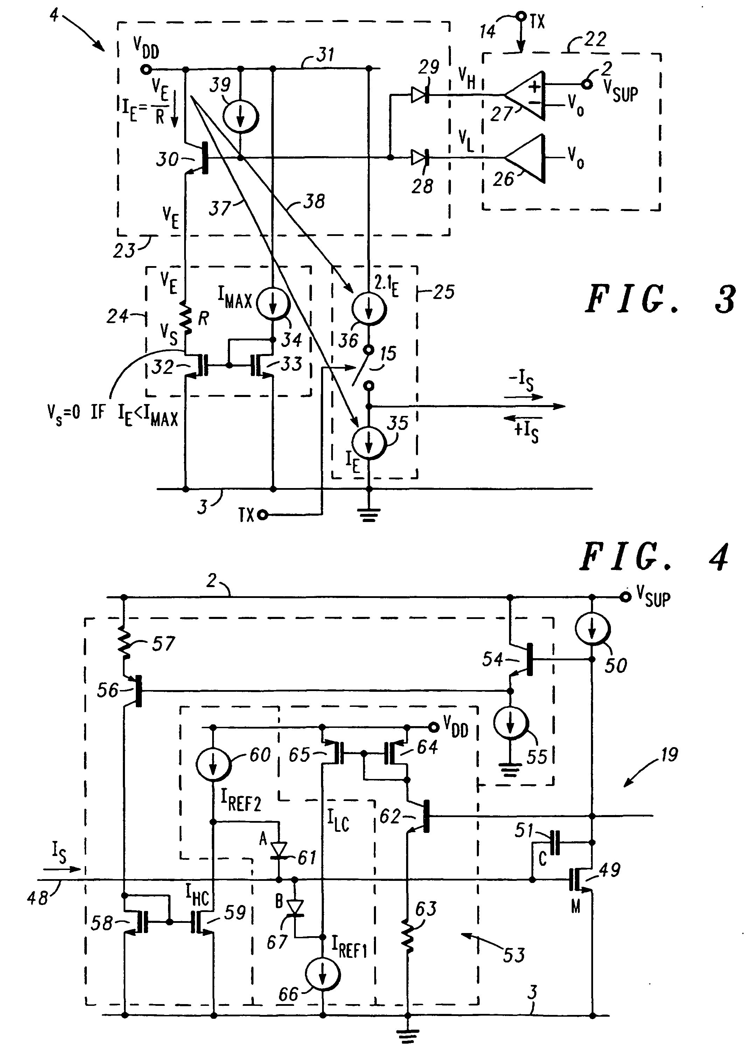

A preferred embodiment of the signal generator shown in Figure 2 is illustrated in Figure 3. The voltage generator 22 comprises a first voltage generator element 26, whose input is connected to receive the $V_O$ voltage across the integrator 19' and a second voltage generator element 27 having an inverted input connected to receive the voltage $V_O$ and a direct input connected to receive the supply voltage $V_{SUP}$. The output of the first generator element 26 produces the feedback voltage $V_L$ and the output of the second generator element 27 produces the feedback voltage $V_H$.

The selection circuit 23 comprises a pair of diodes 28 and 29 connected respectively to receive the voltages $V_L$ and $V_H$ on their negative poles, the positive poles being connected to the base of a transistor 30. The collector of the transistor 30 is connected to an internal power supply line 31 at a substantially lower voltage than the LIN bus power supply line 2. A current generator 39 is connected between the supply line 31 and the base of the transistor 30. The emitter of the transistor 30 is connected to one terminal of the resistor R of the feedback current generator 24.

The feedback current generator 24 also comprises a first field effect transistor ('FET') 32 whose drain is connected to the other terminal of the Resistor, and whose source is connected to the ground line 3. The gate of the FET 32 is connected to the gate of a further FET 32, whose source is also connected to the ground line 3 and whose drain is shorted to its gate and is also connected through a current generator 34 to the voltage supply line 31.

The charging current generator and inverter 25 generates a shaped current $I_S$ and comprises first and second current mirrors 35 and 36 that are driven by the current $I_E$ in the transistor 30 and the resistor R as indicated by the arrows 37 and 38, the current flowing in the mirror 35 being equal to $I_E$ and the current generated in the mirror 36 being $2.I_E$. The current mirror 35 is connected to the integrator 19' directly and the mirror 36 is connected to the integrator 19' through the switch 15.

In operation, the diodes 28 and 29 select the lower of the voltages $V_L$ and $V_H$ at the outputs of the voltage generator elements 26 and 27. As long as the selected voltage is positive, it is applied across the resistor R and the FET 32, the FET 33 and current generator 34 serving to clamp the feedback current $I_E$ at a maximum value $I_{MAX}$. The operation of the switch 15 serves to select the inversion or not of the shaped current $I_S$ applied to the integrator 19'. A starting current for the transistor 30 is provided by the current generator 39 connected between the voltage supply line 31 and the base of the transistor 30.

The integrator circuit 19' of this embodiment of the present invention is shown in figure 4. The shaped current $Is$ from the inverter 25 arrives on a connection 48 which is connected with the gate of an FET 49. The source of the FET 49 is connected to ground and the drain of the FET 49 is connected to the high voltage supply terminal 2 through a source of constant current 50. The capacitor C of the integrator, at 51, is connected between the source and the gate of the FET 49.

The FET 49 is a simple metal-oxide-silicon ("MOS") amplifier and the current source 50 supplies a current of the order of 1 mA. A few micro amperes flow in the capacitor 51 as it charges or discharges.

Perturbations of the voltage $V_O$ at the drain of the FET 49 can be absorbed by the current source 50, since the feedback loops controlling the FET 49 maintain the gate of the FET 49 at a constant positive bias voltage less than the saturation value in both high and low steady state conditions where the voltage $V_O$ is not intended to change. In other words, the integrator 19' presents a low output impedance to perturbation from electromagnetic interference and accordingly presents a low electromagnetic susceptibility.

It will be appreciated that when the shaped current $I_S$ flows towards the gate of the FET 49, the voltage $V_O$ will tend to reduce, whereas when the shaped current $I_S$ flows away from the gate of the FET 49, the voltage $V_O$ will tend to rise. If the voltage $V_O$ reaches the supply voltage $V_{SUP}$ or the ground voltage, the FET will saturate or cut off, the voltage $V_O$ will no longer change, but the voltage of the gate of the FET 49 will continue to rise or fall. This would be undesirable, because the capacitor 51 will continue to charge until the next rising or falling edge of the rectangular input signal TX and, since the shaped current $I_S$ will start at a low magnitude at the next edge, there will be a substantial delay until the voltage across the capacitor 51 reaches a value such that the FET 49 resumes linear operation.

Accordingly, two further feedback loops, 52 and 53, are provided to divert current from the connection 48 during the high and low steady state conditions of the voltage $V_O$.

The feedback loop 52 comprises an NPN transistor 54 whose base is connected to receive the voltage $V_O$, whose collector is connected to the high supply voltage terminal 2, and whose emitter is connected to ground through a constant current source 55. The emitter of the transistor 54 is connected to the base of a PNP transistor 56 whose emitter is connected to the high voltage supply terminal 2 through a resistor 57 across which the difference between the voltage $V_O$ and the high supply voltage $V_{SUP}$ is applied, the base emitter voltages of the transistors 54 and 56 cancelling each other out. The collector of the transistor 56 is connected to ground through the drain-source terminals of a FET 58, whose gate is connected to its drain and which is connected in a PNP current mirror pair with a FET 59, whose gate is connected to the gate of the FET 58, whose source is connected to ground and whose drain is connected to the low voltage supply terminal 31 through a constant current source 60. The connection between the current source 60 and the drain of the FET 59 is connected to the connection 48 through a diode 61, which passes current when the voltage of the drain of the FET 59 is higher than the voltage of the connection 48.

The feedback loop 53 comprises a NPN transistor 62 whose base receives the voltage $V_O$, whose emitter is connected to ground through a resistor 63 and whose collector is connected to the low voltage supply terminal 31 through the drain source path of an FET 64, whose gate is connected to its drain and whose source is connected to the low voltage supply terminal 31, and which is connected in a current mirror pair with an FET 65. The source of the FET 65 is connected to the low voltage supply terminal 31 and the gate of the FET 65 is connected to the gate of the FET 64, the drain of the FET 65 being connected to ground through a constant current source 66. The drain of the FET 65 is connected to the connection 48 through a diode 67, which conducts when the voltage of the drain of the FET 65 is lower than the voltage of the connection 48.

When an edge of the rectangular input signal TX applied to the terminal 14 causes the shaped current $I_S$ to flow towards the gate of the FET 49 and the capacitor 51 so as to tend to discharge the capacitor 51, the voltage $V_O$ reduces until it reaches a value substantially equal to the base emitter voltage of the transistor 62. In order to maintain the voltage $V_O$ at this value, in spite of any interference perturbations, the circuit maintains a small value of the shaped current $I_S$ flowing towards the gate of the FET 49. The current flowing in the resistor 63 is proportional to the voltage $V_O$ and this current also flows in the FET 64 and is reproduced in the FET 65 as a current $I_{LC}$. As soon as $I_{LC}$ becomes less than the current $I_{REF1}$ flowing in the constant current source 66, the diode 67 will become conductive and will divert excess amounts of the shaped current $Is$ away from the capacitor 51. In this condition, the feedback loop 53 keeps the FET 49 biased to keep a drain source current substantially equal to that generated by the current source 50 and the charging current flowing in the capacitor 51 is reduced substantially to zero.

At an edge of the rectangular input signal TX such that the voltage $V_O$ starts to rise, the shaped current $I_S$

flows away from the gate of the FET 49 and capacitor 51. The voltage $V_O$ rises towards $V_{SUP}$ in order to keep the voltage $V_O$ at a high value during the steady state of the rectangular input signal TX, the circuit keeps a small current $I_S$ flowing away from the gate of the FET 49 during the steady state of the signal TX. When the difference between the voltage $V_O$ and the high voltage supply $V_{SUP}$ reaches the base emitter voltage of the transistor 56, the current flowing in the resistor 57 and the FET 58 reduces towards zero and the current $I_{HC}$ flowing in the FET 59 reduces towards zero. As soon as $I_{HC}$ becomes less than the current $I_{REF2}$ flowing in the current source 60, the diode 61 will become conductive, and excess amounts of the shaped current $Is$ will be diverted through the source 60 away from the connection 48 so as to keep the FET 49 still in linear operation without saturating and, again, the charging current flowing in the capacitor 51 is substantially equal to zero.

Referring now to Figure 5, while the magnitude of the voltage $V_O$ is between two limit values and the feedback current $I_S$ is less than a maximum value $I_{MAX}$, during a first phase 40 starting at the rising edge of the data signal at the terminal 14, the shaped current $I_S$ varies as follows:

$$C\frac{dV}{dt} = \frac{V_o}{R} \qquad \text{Equation 1}$$

where $V$ is the voltage across the capacitor 51. Accordingly, during this first phase, the voltage $V_O$ decreases as an exponential function of time, its rate of decrease progressively increasing.

During a second phase 41, the shaped current $I_S$ varies as follows:

$$I_S = I_{MAX} = const \; ; \; C\frac{dV}{dt} = I_{MAX} \qquad \text{Equation 2}$$

Accordingly, during the second phase 41, the voltage $V_O$ decreases linearly with time.

During a third phase 42, the voltage $V_O$ continues to decrease as an exponential function of time, but with its rate of change progressively decreasing. The voltage $V_O$ subsequently remains constant during a fourth phase 43. It will be appreciated that, throughout the three phases 40 to 42, the shaped current $Is$ and the charging current $I_C$ have continuous magnitudes that are progressive functions of the $V_O$, so that the rate of change of the $V_O$ never exceeds maximum values as would be the case with step-wise, discontinuous changes in the charging current. Subsequent phases 44, 45 and 46 mirror the phases 42, 41 and 40 with the current inverted so that the capacitor is progressively charged up to the $V_{SUP}$ in response to the falling edge of the data signal TX at the terminal 14.

The charging current is proportional to the feedback voltage $V_E$ from the selection circuit 23 divided by the value of the resistor R until the current reaches the maximum value $I_{MAX}$ defined by the generator 34 and FET 33. This half cycle of variation of the output voltage corresponds with a close approximation to a pure sinusoidal half cycle, so that electromagnetic emissions on the LIN bus 1 are limited to a single base frequency with little contribution from harmonics of that base frequency. The base frequency is a relatively low frequency, which can readily be chosen to be compatible with acceptable standards.

In the steady state conditions of the rectangular input signal TX, when the magnitude of the voltage $V_O$ reaches a lower limit value as in phase 43 of Figure 5, the shaped current $I_S$ is diverted through the FET 65 and the current source 66, so that the charging/discharging current $I_C$ in the capacitor 51 is:

$$I_C = C\frac{dV}{dt} = I_S - (i_{REF1} - k_1(V_O - V_{BE})) \cong 0 \qquad \text{Equation 1}$$

where $k_1$ is defined by the resistance of the resistor 63.

When the magnitude of the voltage $V_O$ reaches an upper limit value, the charging/discharging current $I_C$ in the capacitor 51 is:

$$I_C = C\frac{dV}{dt} = -I_S + (i_{REF2} - k_2(V_{SUP} - V_O)) \cong 0 \qquad \text{Equation 2}$$

where $k_2$ is defined by the resistance of the resistor 57.

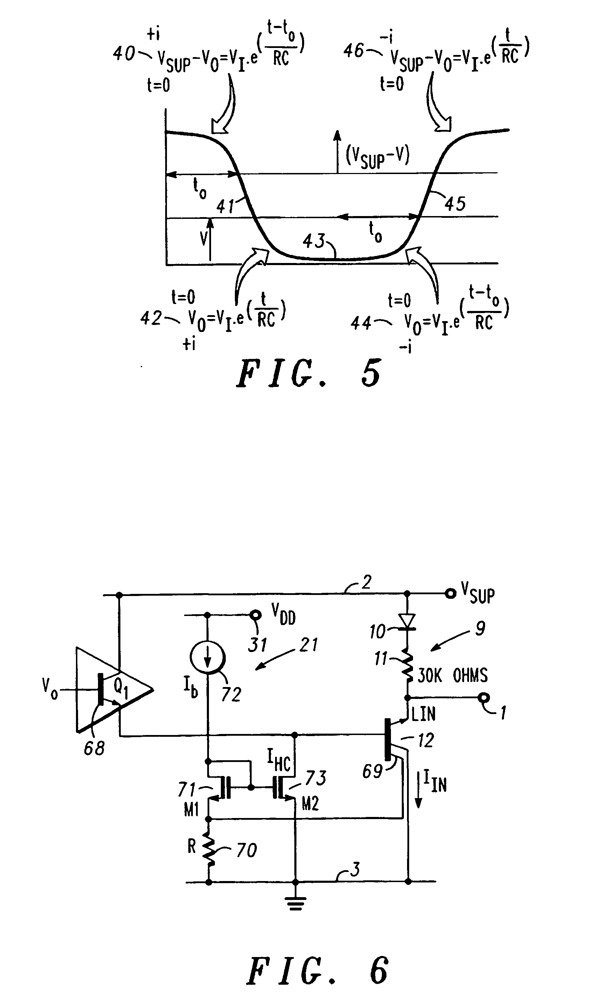

Figure 6 shows in more detail a preferred embodiment of the follow up stage 21. Due to the low impedance of the integrator 19', in this preferred embodiment of the invention, a single NPN transistor 68 is used, whose base is connected to receive the voltage $V_O$ from the current source 50 and FET 49, whose collector is connected to the high voltage supply terminal 2, and whose emitter is connected to the base of the output power transistor 12. A feedback loop is provided by forming a second collector 69 on the transistor 12 and a resistor 70 is connected between the second collector 69 and ground. The junction between the collector 69 and the resistor 70 is connected to the source of an NPN FET 71 whose drain is connected through a constant current source 72 to the low voltage supply common base of FETs 71 and 73 is connected to the drain of the FET 71, the source of the FET 73 is connected to ground and the drain of the FET 73 is connected to the base of the transistor 12. The NPN follower transistor 68 is only able to supply current in this configuration and the current mirror arrangement with the FETs 71 and 73 is arranged to pull down the base current of the power transistor 12. The circuit is arranged to have fast reactions, since the parasitic interference current injection may occur at frequencies ranging from 1 to 100 MHz, for example. In particular, the circuit arrangement is arranged to keep the LIN output voltage below the threshold of the LIN receiver when $V_O$ is low, even if a perturbation current of a few hundred milli-amperes is in check in this frequency range, for example.

**Claims**

1. A transmitter (4) for a controlled-shape switched signal on a communication line (1) comprising signal generator means including capacitor means (C) and feedback loop means responsive to a voltage across said capacitor means (C) and to an input signal (TX) for supplying a shaped current ($I_S$) for charging said capacitor means (C) for defining an edge of said switched signal, and signal producing means (9, 21) responsive to said capacitor voltage for applying said controlled-shape switched signal to said line,

   **characterised in that** said signal generator means includes amplifier means (49) having an input terminal and an output terminal across which said capacitor means (C) is connected and at which it generates an amplifier output voltage ($V_O$), said feedback loop means being for maintaining minimum value of said shaped current ($I_S$) at least in steady state conditions of said input signal (TX), said signal generator means comprising first and second current diversion means (52, 53) operative at least in said steady state conditions in response to relative magnitudes of said amplifier output voltage ($V_O$) and first and second limit voltages respectively for controlling supply of shaped current ($I_S$) to said amplifier means and said capacitor means (C) so as to tend to reduce charging and discharging of said capacitor means (C) in said steady state conditions and to maintain a steady state magnitude of said amplifier output voltage ($V_O$) even against fluctuations induced by electromagnetic perturbations on said communication line.

2. A transmitter as claimed in claim 1, wherein said first and second diversion means (52, 53) comprise first and second variable current generator means (54-59, 62-65) for generating first and second variable currents ($I_{HC}$, $I_{LC}$) that are functions of said relative magnitudes of said amplifier output voltage ($V_O$) and said first and second limit voltages respectively, first and second reference current generator means (60, 66) for generating first and second reference currents ($I_{REF1}$, $I_{REF2}$), and first and second unidirectional means (61, 67) for selectively coupling the respective current generator means (54-60, 62-66) to said amplifier means (49) and to said capacitor means (C) in response to relative magnitudes of the respective variable currents ($I_{HC}$, $I_{LC}$) and reference currents ($I_{REF1}$, $I_{REF2}$).

3. A transmitter as claimed in claim 1 or 2, wherein said amplifier means (49) presents a high input impedance, the impedance presented between the output of said amplifier (49) and a first supply terminal (3) being a function of the voltage at an input of said amplifier, and an output of said amplifier (49) being connected to a second supply terminal (2) through a source of substantially constant current (50).

4. A transmitter as claimed in claim 1 or 2, wherein said signal producing means (9, 21) comprises first and second transistor stages (68, 12) in a cascaded voltage follower configuration, a source of a substantially constant control current (72), a positive feedback loop (69-71) for feeding back a positive feedback voltage that is a function of an output voltage from said second transistor stage (12) with a gain less than unity, and means (73) responsive to the sum of a current that is a function of said feedback voltage and said control current for controlling supply of current to an input of said second transistor stage (12) so as to tend to maintain the magnitude of said controlled-shape switched signal applied to said communication line as a function of said amplifier output voltage ($V_O$) against fluctuations induced by electromagnetic perturbations on said communication line.

**Patentansprüche**

1. Sender (4) für ein geschaltetes Signal mit kontrollierter Form auf einer Kommunikationsleitung (1), der Signalerzeugermittel umfasst, die Kondensatormittel (C) und Rückkopplungsschleifenmittel umfassen, die auf eine Spannung an den Kondensatormitteln (C) und auf ein Eingangssignal (TX) ansprechen, zum Zuführen eines geformten Stromes ($I_s$) zum Laden der Kondensatormittel (C), zum Definieren einer Flanke des geschalteten Signals, und der Signalerzeugungsmittel (9, 21) umfasst, die auf die Kondensatorspannung ansprechen, zum Anlegen des geschalteten Signals mit kontrollierter Form an die Leitung,

**dadurch gekennzeichnet, dass** die Signalerzeugermittel Verstärkermittel (49) umfassen, die über einen Eingangsanschluss und einen Ausgangsanschluss verfügen, an denen die Kondensatormittel (C) angeschlossen sind und an denen sie eine Verstärkerausgangsspannung ($V_O$) erzeugen, wobei die Rückkopplungsschleifenmittel mindestens in stationären Zuständen des Eingangssignals (TX) einer Aufrechterhaltung eines minimalen Wertes des geformten Stromes ($I_s$) dienen, wobei die Signalerzeugermittel erste und zweite Stromumleitungsmittel (52, 53) umfassen, die mindestens in den stationären Zuständen in Reaktion auf relative Größen der Verstärkerausgangsspannung ($V_O$) und erste beziehungsweise zweite Grenzspannungen wirken, zum Steuern der Zuführung eines geformten Stromes ($I_s$) zu den Verstärkermitteln und den Kondensatormitteln (C), um so darauf abzuzielen, ein Laden und Entladen der Kondensatormittel (C) in den stationären Zuständen zu verringern und eine Größe des stationären Zustandes der Verstärkerausgangsspannung ($V_O$) auch gegen Schwankungen aufrecht zu erhalten, die durch elektromagnetische Störungen auf der Kommunikationsleitung hervorgerufen werden.

2. Sender gemäß Anspruch 1, wobei die ersten und zweiten Umleitungsmittel (52, 53) erste und zweite variable Stromerzeugermittel (54 - 59, 62 - 65) zum Erzeugen von ersten und zweiten variablen Strömen ($I_{HC}$, $I_{LC}$), die Funktionen der relativen Größen der Verstärkerausgangsspannung ($V_O$) und der ersten beziehungsweise zweiten Grenzspannungen sind, erste und zweite Referenzstromerzeugermittel (60, 66) zum Erzeugen erster und zweiter Referenzströme ($I_{REF1}$, $I_{REF2}$) und erste und zweite unidirektionale Mittel (61, 67) zum selektiven Koppeln der jeweiligen Stromerzeugermittel (54 - 60, 62 - 66) an die Verstärkermittel (49) und die Kondensatormittel (C), in Reaktion auf relative Größen der jeweiligen variablen Ströme ($I_{HC}$, $I_{LC}$) und Referenzströme ($I_{REF1}$, $I_{REF2}$) umfassen.

3. Sender gemäß Anspruch 1 oder 2, wobei die Verstärkermittel (49) eine hohe Eingangsimpedanz zeigen, wobei die zwischen dem Ausgang des Verstärkers (49) und einem ersten Versorgungsanschluss (3) gezeigte Impedanz eine Funktion der Spannung an einem Eingang des Verstärkers ist, und wobei ein Ausgang des Verstärkers (49) mit einem zweiten Versorgungsanschluss (2) durch eine Quelle eines im Wesentlichen konstanten Stromes (50) verbunden ist.

4. Sender gemäß Anspruch 1 oder 2, wobei die Signalerzeugungsmittel (9, 21) umfassen: erste und zweite Transistorstufen (68, 12) in einer kaskadierten Spannungsfolgerkonfiguration, eine Quelle für einen im Wesentlichen konstanten Steuerstrom (72), eine positive Rückkopplungsschleife (69 - 71) zum Rückkoppeln einer positiven Rückkopplungsspannung, die eine Funktion einer Ausgangsspannung von der zweiten Transistorstufe (12) mit einer Verstärkung kleiner als Eins ist, und Mittel (73) die auf die Summe eines Stromes ansprechen, die eine Funktion der Rückkopplungsspannung und des Steuerstromes zum Steuern einer Zuführung von Strom zu einem Eingang der zweiten Transistorstufe (12) ist, um so darauf abzuzielen, die Größe des geschalteten Signals mit kontrollierter Form, das an die Kommunikationsleitung angelegt wird, als eine Funktion der Verstärkerausgangsspannung ($V_O$) gegen Schwankungen aufrecht zu erhalten, die durch elektromagnetische Störungen auf der Kommunikationsleitung hervorgerufen werden.

**Revendications**

1. Emetteur (4) pour un signal commuté de forme contrôlée sur une ligne de communication (1) comprenant un moyen générateur de signal comprenant un moyen de condensateur (C) et un moyen de boucle de rétroaction sensible à une tension aux bornes des moyens de condensateur (C) et à un signal d'entrée (TX) pour délivrer un courant mis en forme ($I_S$) pour charger ledit moyen de condensateur (C) pour définir un front dudit signal commuté, et un moyen de production de signal (9, 21) sensible à ladite tension de condensateur pour appliquer ledit signal commuté de forme contrôlée à ladite ligne,

**caractérisé en ce que** ledit moyen générateur de signal comprend un moyen amplificateur (49) ayant une borne d'entrée et une borne de sortie auxquelles ledit moyen de condensateur (C) est connecté et au niveau desquelles il génère un une tension de sortie d'amplificateur ($V_O$), ledit moyen de boucle de rétroaction étant pour maintenir une valeur minimale dudit courant mis en forme ($I_S$) au moins dans des conditions de régime permanent dudit signal d'entrée (TX), ledit moyen générateur de signal comprenant des premier et deuxième moyens de dérivation de courant (52, 53) fonctionnant au moins dans lesdites conditions de régime permanent en réponse à des grandeurs relatives de ladite tension de sortie d'amplificateur ($V_O$) et des première et deuxième tension limites respectivement pour contrôler l'alimentation de courant mis en forme ($I_S$) au dit moyen amplificateur et au dit moyen de condensateur (C) de manière à tendre à réduire la charge et la décharge dudit moyen de condensateur (C) dans lesdites conditions de régime permanent et à maintenir une grandeur de régime permanent de ladite tension de sortie d'amplificateur ($V_O$) même contre des fluctuations provoquées par des perturbations électromagnétiques sur ladite ligne de communication.

2. Emetteur selon la revendication 1, dans lequel lesdits premier et deuxième moyens de dérivation (52, 53) comprennent des premier et deuxième moyens générateurs de courant variable (54-59, 62-65) pour générer des premier et deuxième courants variables ($I_{HC}$, $I_{LC}$) qui sont des fonctions desdites grandeurs relatives de ladite tension de sortie d'amplificateur ($V_O$) et desdites première et deuxième tensions limites respectivement, des premier et deuxième moyens générateurs de courant de référence (60, 66) pour générer des premier et deuxième courants de référence ($I_{REF1}$, $I_{REF2}$), et des premier et deuxième moyen unidirectionnels (61, 67) pour coupler sélectivement les moyens générateurs de courant variable (54-60, 62-66) respectifs au dit moyen amplificateur (49) et au dit moyen de condensateur (C) en réponse aux grandeurs relatives des courants variables ($I_{HC}$, $I_{LC}$) et des courants de référence ($I_{REF1}$, $I_{REF2}$) respectifs.

3. Emetteur selon la revendication 1 ou 2, dans lequel ledit moyen amplificateur (49) présente une haute impédance d'entrée, l'impédance présentée entre la sortie dudit amplificateur (49) et une première borne d'alimentation (3) étant une fonction de la tension sur une entrée dudit amplificateur, et une sortie dudit amplificateur (49) étant connectée à une deuxième borne d'alimentation (2) à travers une source de courant sensiblement constant (50).

4. Emetteur selon la revendication 1 ou 2, dans lequel ledit moyen de production de signal (9, 21) comprend des premier et deuxième étages de transistor (68, 12) dans une configuration de poursuite de tension en cascade (72), une boucle de rétroaction (69-71) pour réinjecter une tension de rétroaction positive qui est une fonction d'une tension de sortie provenant dudit deuxième étage de transistor (12) avec un gain inférieur à un, et des moyens (73) sensibles à la somme d'un courant qui est une fonction de ladite tension de rétroaction et dudit courant de commande pour contrôler l'alimentation de courant sur une entrée dudit deuxième étage de transistor (12) de manière à tendre à maintenir la grandeur dudit signal commuté à forme contrôlée appliqué à ladite ligne de communication comme une fonction de ladite tension de sortie d'amplificateur ($V_O$) contre des fluctuations provoquées par des perturbations électromagnétiques sur ladite ligne de communication.

*FIG. 1*

*FIG. 2*

*FIG. 3*

*FIG. 4*

$$40 \sim \overset{+i}{\underset{t=0}{V_{SUP}-V_0=V_I \cdot e^{\left(\frac{t-t_0}{RC}\right)}}} \qquad 46 \sim \overset{-i}{\underset{t=0}{V_{SUP}-V_0=V_I \cdot e^{\left(\frac{t}{RC}\right)}}}$$

$$42 \sim \underset{+i}{\overset{t=0}{V_0=V_I \cdot e^{\left(\frac{t}{RC}\right)}}} \qquad 44 \sim \underset{-i}{\overset{t=0}{V_0=V_I \cdot e^{\left(\frac{t-t_0}{RC}\right)}}}$$

*FIG. 5*

*FIG. 6*